# EUROPEAN PATENT APPLICATION

(11) **EP 3 780 391 A1**
(43) Date of publication of application: **17.02.2021**
(21) Application number: 19781302.5
(22) Date of filing: 05.04.2019
(51) Int. Cl.: H03G 1/02, G10H 1/34

(54) **DEVICE FOR THE REMOTE CONTROL OF A PLURALITY OF ANALOGUE POTENTIOMETERS OF AN AMPLIFIER OF A MUSICAL INSTRUMENT**

(30) Priority: 05.04.2018 ES 201830337
(71) Applicant: Vidal Martinez, Bernardo, Buñol (Valencia) (ES)
(72) Inventor: Vidal Martinez, Bernardo, Buñol (Valencia) (ES)
(74) Representative: Rodriguez Oca, Jesus
(86) International application number: PCT/ES2019/070234
(87) International publication number: WO 2019/193235

(57) **Abstract**

The invention relates to a device (10) for the remote control of a plurality of analogue potentiometers of an amplifier (30) of a guitar-type or bass guitar-type musical instrument, which device comprises a programmable control card (20) for configuring the potentiometers of the device (10), each configuration corresponding to a particular musical mode, and a pedal (40) with a number of actuators that corresponds to the number of potentiometers of the amplifier (30). The amplifier (30) is a mono-channel or two-channel amplifier. The invention also relates to a method for operating a device (10) for the remote control of at least one analogue potentiometer of an amplifier (30) of a musical instrument.

## Description

### Field of the invention

The object of the present invention is a device for the remote control (with or without cable) of the analogue potentiometers of the amplifiers of electric musical instruments, in particular guitar-type or bass guitar-type instruments.

### Background of the invention

Electric or electroacoustic guitars or electric bass guitars comprise electronic amplifiers, designed to amplify different electrical sound signals emitted by these apparatus. Furthermore, the tone emitted by these instruments can be modified by emphasizing or attenuating certain frequencies, volume, harmonic distortion, etc., being also possible to add certain guitar effects, such as distortion or reverberation among others (if the amplifier itself does not have them).

Typically, these amplifiers consist of two steps of amplification circuits, being also common that they are further provided with saturation / harmonic distortion control and an equalization circuit: the first step is a preamplifier, which amplifies the guitar signal to a level that can stimulate the power step; the power or output step increases the amplitude of the input signal until it causes the speaker to produce sound.

In these musical instruments (electric guitars or bass guitars), effects or signal manipulations take place: these are digital, analogue or acoustic alterations in the tone or sound of the musical instrument, so that the music emitted can be characterized and modified as desired, specifically by choosing the amount of high and low frequencies that the final sound will have, as well as the volume, harmonic distortion, reverberation or any other effect, if the amplifier has them.

Potentiometers, typically analogue potentiometers, present in the previous amplifiers, are capable of varying the output voltage of the amplifier circuit so that its output signal is modulated to the speaker, and the equalization, the amount of harmonic distortion and effects like reverberation, chorus, etc., are varied if it has them.

In the instruments known in the prior art, amplifiers cannot be manipulated by a musician (bassist or guitar player) during his / her musical performance, since he / she is using his / her hands to play the instrument, so that he / she has to comply with established parameters on the amplifier connected to said instrument before the performance. In this way, the musician has to limit himself / herself to playing in accordance with parameters established on his / her amplifier before the performance (generally analogue amplifier, tube amplifier and with 1 or 2 channels); as only option would be the two-channel amplifiers offering 2 sound configurations.

Amplifiers with variable configurations, capable of modifying sounds and their configurations, such as for example those described in patent document US 6724897 B1 are known in prior art. However, these amplifiers cannot be programmed during the course of a musical performance. Devices capable of varying, among others, tone, frequency and volumen of a guitar-type musical instrument are also known, as described in WO 2007067326 A2, for example, or in EP 1727122 A1. However, with these devices it is not possible to vary sound configuration of the instrument during a performance. Pedals connected to musical instruments allowing the volume to be varied are also known in prior art as described for example in US 5274710 A. Similarly, it is not possible to change sound configurations during the course of a performance. A pedal mixing sounds for an amplifier is also known, as described in patent document CA 2031723 A, for example. However, no modifications can be made during the performance either. US 2005252363 A1 describes sound controls to make them more intense during the use of an instrument; however, it is not possible to modify other parameters of the musical instrument.

It is also known in prior art, for example in patent document US 9589549 B1, a remote control device with a known robotic mechanism to more conveniently use an expression pedal in an audio signal electromechanical control system. This known system allows to control an adjustable mechanism by means of a rotating control via a pedal, and without the musician having to free his hands. The expression pedal provides a variable voltage signal that is received by a controller, which responds with a certain electrical current based on the input. However, this type of robotic system is very limited, and only allows controlling a single potentiometer, or a single element, but does not allow to take advantage of all the sonic palette that the amplifier can offer.

The present invention aims to ensure that guitar players and bassists can establish all their amplifier configurations (generally analogue and tube), in order to obtain any possible kind of sound and not settle for how it is prepared before the performance. Furthermore, the device of the invention allows not having to make use of what is always practically done, which is to use distortion pedals, overdrive, boosters (to increase volume), equalizers, etc., that avoid obtaining all the sonic possibilities of the authentic sound of the amplifier itself: when those elements are used, the sound is colored and the best sonic possibility is eliminated, which is that of the sound of the amplifier itself with its almost infinity of possible combinations.

### Summary of the invention

According to a first aspect, the invention relates to a device for the remote control of at least one analogue potentiometer of an amplifier of a guitar-type or bass guitar-type musical instrument, which device comprises a programmable control card for configuring the at least one potentiometer of the device, and a pedal with a number of actuators that corresponds to the number of potentiometers of the amplifier.

The amplifier can be mono-channel or two-channel. Typically, the amplifier comprises angle sensors for each potentiometer, as well as elements for the forward and / or backward motorization of said potentiometers, preferably servo drives.

In the device of the invention, the pedal preferably comprises an actuator for calibrating said pedal. Furthermore, the pedal is typically of an analogue type.

In the device of the invention, the card typically programs each potentiometer with a certain configuration, defined in terms of its position, advance and / or retreat.

Preferably, the device of the invention is connected to an amplifier of an electric guitar or bass guitar.

According to a second aspect, the invention relates to a method for operating a device for the remote control of at least one analogue potentiometer of an amplifier of a musical instrument as defined, comprising the following steps:
- contact closure on pedal to activate a digital input corresponding to a certain mode on the card;
- the card, by means of its microprocessor, compares the reading of the position of each one of the potentiometers with the one desired in the interpretation mode that has been pressed on the pedal;
- reading of current position of each potentiometer: if the same is greater than the one desired in pulsed mode, a digital output from the card will be activated to the amplifier to rotate the potentiometer anticlockwise; if the position reading of a certain potentiometer is, on the contrary, less than the one desired for the mode in question, a digital output from the card will be activated to the amplifier to rotate the potentiometer in question clockwise;
- the cycle is repeated as many times as necessary and ends when the position reading of the potentiometer in question is equal to that desired in the mode in question indicated by the action of the musician on the pedal;
- repetition of the previous steps for the remaining potentiometers of the amplifier, making the position of each one of them the desired one in the mode in question that was defined when pressing the pedal.

Other features, advantages, and objects of the present invention will be apparent to one skilled in the art upon reading the following detailed description of the preferred embodiment of the invention.

### Brief description of the drawings

To complement the description that is going to be made below and in order to provide a better understanding of the characteristics of the invention, according to a preferred example of practical implementation thereof, it is attached as an integral part of said description, a set of figures wherein, for illustrative and non-limiting purposes, the following has been represented:

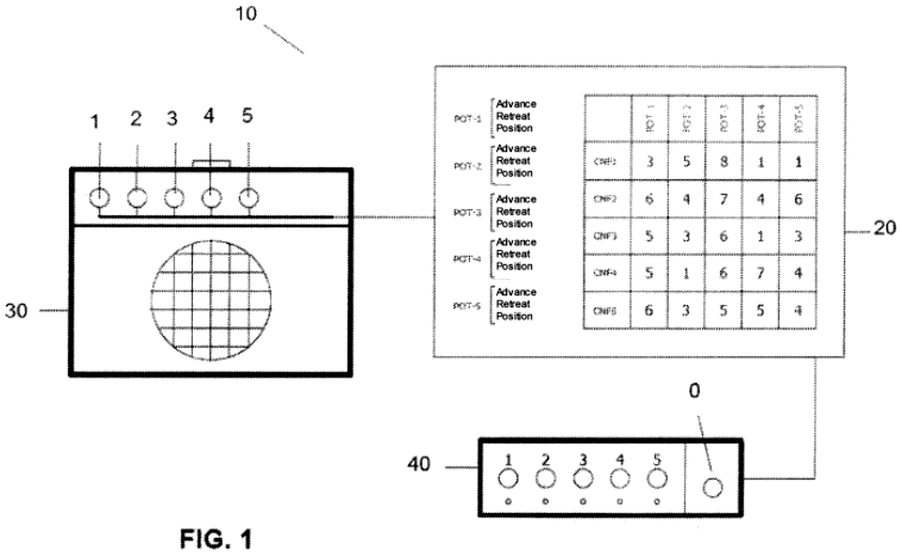

Figure 1 shows a diagram of the device for the remote control of analogue potentiometers of electric musical instruments according to the present invention.

### Detailed description of the preferred embodiment

The present invention refers to a device 10 for the remote control of one or more analogue potentiometers of electric musical instruments, in particular guitar-type or bass guitar-type instruments: these potentiometers are present in the amplifier 30 of said instruments, as shown in a diagram in Figure 1.

The device 10 of the invention is a device with a simple mechanical or robotic programming, which is preferably actuated by means of a pedal 40 in order to be able to actuate the potentiometers of the amplifier 30 for electric guitar or electric bass guitar and thus be able to have all the possible combinations offered by these potentiometers, preferably of analogue type, to obtain the desired sound from the amplifier 30 at any time.

The device 10 of the invention can be used to generally control the potentiometers of any analogue effect pedal.

A standard amplifier of a guitar-type or bass guitar-type musical element cannot be manipulated by the musician during the performance of a song to vary the sound, as his / her hands are busy playing his / her instrument. On many occasions, the fact of manually actuating the potentiometers of an amplifier between songs is very cumbersome and complicated for the musician since, in the best of cases, he / she has only a few seconds of silence between songs to be able to perform this task. It is for this reason that it is usual to leave a sound in the amplifier (typically it is a mono-channel amplifier) and with that amplifier sound do all the performance. In case the instrument has an amplifier with two or more channels, the above is equally applicable, since the musician likes, for each song, to vary the sound of the amplifier to a greater or lesser extent to perfectly adapt it to each song. Also within the same song, it is very common that there are two, three or more different sounds, although with current amplifiers, they are left programmed from the beginning of the song and are not modified during its performance, for the reasons mentioned above. In summary, a standard amplifier used in these electric musical devices has never developed even a minimum part of its sonic capacity (depending on the position of its potentiometers), and it often remains static throughout the concert. The advantage of the present device of the invention is that a musician can take advantage of the full sonic palette the amplifier can offer at any time during the performance.

The device 10 of the present invention is typically used in mono-channel amplifiers 30 (both traditional and current) although it can also be used in any two-channel amplifier to take advantage of the two sounds of the amplifier itself.

In turn, the device 10 of the invention can also be used in potentiometers of analogue pedals (generally the most sought-after) to be able to use, as in amplifiers 30 of musical instruments, any combination offered by all pedals and never have to do it between songs. Furthermore, with standard amplifiers, it is practically impossible to make configuration variations within the same song one or more times, something that will be allowed by the device of the invention.

Referring to Figure 1, the device 10 of the invention comprises an amplifier 30 of a musical instrument. In turn, said amplifier 30 comprises several potentiometers, five in the example shown in Figure 1, numbered from 1 to 5. Potentiometers 1-5 of amplifier 30 are motorized: the amplifier comprises angle sensors for each potentiometer, as well as elements for the forward and / or backward motorization of said potentiometers, preferably servo drives. In turn, the amplifier 30 is connected to a programmable control card 20 wherein the configuration of each one of the potentiometers 1-5 of the device 10 can be programmed. The configuration of each one of said potentiometers is given by its position, advance and / or retreat, as shown schematically in the configuration of the card 20. In turn, the device 10 comprises a pedal 40 with five actuators, numbered from 1 to 5, each corresponding to one of the potentiometers of amplifier 30. Pedal 40 further comprises, as shown in Figure 1, a pedal calibration actuator 0. Pedal 40 is preferably an analogue-type pedal. By means of this actuator 0, it is possible to select the song to be interpreted or programmed and once it is selected, by means of the remaining pedal actuators (1 to 5 in the example shown) the potentiometers of an amplifier 30 will be programmed.

The programmable card 20, associated with the potentiometers of the amplifier, must be programmed before a performance: thus, each potentiometer (1 to 5, in the case of the example shown) will have associated a specific configuration, defined in terms of position, advance and / or retreat, for each programmed performance mode. Depending on the songs to be performed, the musician will leave said card 20 programmed in terms of the desired sounds for his / her performance. Each one of these programmed configurations will correspond to a specific musical mode. The different configurations of the potentiometers, defined in terms of their position, advance and / or retreat, can be stored in a memory provided in the device for this purpose.

During a performance, when a musician presses a button or actuator on pedal 40, a normally open contact on said pedal 40 will close, which will activate a digital input corresponding to the pulsed mode on card 20. Card 20, through its microprocessor, will compare the reading of the position of each one of the potentiometers (1 to 5 in this case) with the desired one in the interpretation mode that has been pressed on pedal 40. For each one of the potentiometers 1 to 5, its current position will be read: if it is greater than desired in pulsed mode, a digital output from card 20 to amplifier 30 will be activated to rotate the potentiometer in question anticlockwise (via a servo drive); if the position reading of a certain potentiometer is, on the contrary, smaller than the desired one for the mode in question, a digital output from card 20 to amplifier 30 will be activated to rotate the potentiometer in question clockwise (via a servo drive). The cycle that has just been defined ends at the moment wherein the reading of the position of the potentiometer in question is equal to that desired in the mode in question indicated by the action of the musician on pedal 40. The same is repeated for the remaining potentiometers of an amplifier, making the position of each one of them the desired one in the mode in question that was defined by pressing pedal 40. All this operation is very fast, and it is around simply milliseconds. Card 20 is in charge of receiving signals or commands from pedal 40, and it is also in charge of giving corresponding commands to potentiometers of an amplifier 30.

According to a possible embodiment of the invention, pedal 40 is made with travel, in such a way that it allows to select in real time the position of the potentiometers of the device 10, typically of the gain or volume potentiometers. Pedal with travel is known as expression pedal, and it must be differentiated from pedals known as "footswitch" that only allow an on / off switch, without travel.

Furthermore, control card 20 of the device 10 of the invention can be programmed in such a way as to vary the actuation time of travel of each one of the potentiometers, configured by said card 20. This functionality is important with regard to the quality of technical and musical interpretation, as it will have a very positive influence on the expressiveness of the musician to change the sound during his performance, which he / she will do practically instantly or with enough time to progressively soften the sound (known as "fade in, "fade out").

In short, the invention represents a very important qualitative leap over the known prior art as it is much more functional and complex than known devices. Thanks to programmable control card (20), the artist can easily choose a song within a plurality of them and within each song, several "presets" (potentiometer configurations). The device is programmed to be controlled by means of a joystick or "multi-joystick" (not shown in the figure) that controls and programs the position of each one of the potentiometers, and the artist can also choose, in real time, the change process speed of "preset".

Finally, according to an alternative embodiment of the invention, the device 10 of the invention can also be controlled by voice, as a complementary or alternative way to the control by means of pedal 40. The change of presets (both of song and program) will be then carried out using a mini microphone or headset microphone or a microphone in contact with the musician's glottis (via wireless or cable). This embodiment is mainly intended for physically disabled people with impairments in the legs, although it can be used by any other musician in order to be able to use the device of the invention without having to use pedal 40. Typically, the voice command of the device of the invention would be a number (to select for example a song) and a letter (to select for example the preset of the selected song).

Although the present invention has been described with reference to a preferred embodiment thereof, other modifications and alterations may be made by a person skilled in the art having ordinary knowledge thereof, without abandoning the object of the present invention, which is defined in the appended claims.

## Claims

1. A device (10) for the remote control of a plurality of analogue potentiometers of an amplifier (30) of a guitar-type or bass guitar-type musical instrument, comprising a programmable control card (20) for the configuration of the potentiometers of a device (10), each configuration corresponding to a specific musical mode and a pedal (40) with a number of actuators corresponding to the number of potentiometers of the amplifier (30).

2. The device (10) according to claim 1, wherein amplifier (30) is a mono-channel or two-channel amplifier.

3. The device (10) according to any one of the preceding claims, wherein amplifier (30) comprises angle sensors for each potentiometer, as well as elements for the forward and / or backward motorization of said potentiometers, preferably servo drives.

4. The device (10) according to any one of the preceding claims, wherein pedal (40) comprises an actuator (0) for calibrating said pedal.

5. The device (10) according to any one of the preceding claims, wherein pedal (40) is of analogue type.

6. The device (10) according to any one of the preceding claims, wherein the card (20) programs each potentiometer with a certain configuration, defined in terms of its position, advance and / or retreat.

7. The device (10) according to any one of the preceding claims, connected to an amplifier (30) of an electric guitar or bass guitar.

8. The device (10) according to any one of the preceding claims, wherein pedal (40) is a type-expression pedal or a pedal with travel.

9. The device (10) according to any one of the preceding claims, wherein control card (20) is programmable to configure the actuation time of the travel of one or more of the potentiometers of the device.

10. The device (10) according to any one of the preceding claims, comprising at least one storage memory.

11. The device (10) according to any one of the preceding claims, comprising at least one joystick or "multi-joystick" for controlling and programming the position of each one of the potentiometers.

12. The device (10) according to any one of the preceding claims, comprising voice recognition means for controlling and programming the position of each one of the potentiometers.

13. A method for operating a device (10) for the remote control of a plurality of analogue potentiometers of an amplifier (30) of a musical instrument according to any one of claims 1-10, comprising the following steps:
- contact closure on pedal (40) to activate a digital input corresponding to a certain mode on card (20);
- the card (20), by means of its microprocessor, compares the reading of the position of each one of the potentiometers with the one desired in the interpretation mode that has been pressed on pedal (40);
- reading of current position of each potentiometer: if it is greater than the one desired in pulsed mode, a digital output from card (20) will be activated to amplifier (30) to rotate potentiometer anticlockwise; if position reading of a certain potentiometer is, on the contrary, less than the one desired for the mode in question, a digital output from card (20) will be activated to amplifier (30) to rotate the potentiometer in question clockwise;
- the cycle is repeated as many times as necessary and ends when the reading of the position of the potentiometer in question is equal to that desired in the mode in question indicated by the action of the musician on pedal (40);
- repetition of the previous steps for the remaining potentiometers of the amplifier, making the position of each one of them the desired one in the mode in question that was defined when the pedal (40) was pressed.
